**Europäisches Patentamt**

**European Patent Office**

**Office européen des brevets**

(11) Veröffentlichungsnummer: **0 227 945**
**A2**

## (12) EUROPÄISCHE PATENTANMELDUNG

(21) Anmeldenummer: 86116234.5

(22) Anmeldetag: 24.11.86

(51) Int. Cl.4: **H01L 31/02** , H01L 31/06 ,
H01L 31/18

(30) Priorität: 28.11.85 DE 3542116

(43) Veröffentlichungstag der Anmeldung:
08.07.87 Patentblatt 87/28

(84) Benannte Vertragsstaaten:
DE ES FR IT

(71) Anmelder: **Nukem GmbH**
**Rodenbacher Chaussee 6 Postfach 11 00 80**
**D-6450 Hanau 11(DE)**

(72) Erfinder: **Wörner, Jörg, Dr.**
**Philipp-Reis-Strasse 16**
**D-6451 Grosskrotzenburg(DE)**

(74) Vertreter: **Stoffregen, Hans-Herbert, Dr.**
**Dipl.-Phys. et al**
**Salzstrasse 11a**
**D-6450 Hanau/Main 1(DE)**

(54) **Photovoltaische Zelle.**

(57) Es wird eine Dünnschicht-Solarzelle (10) vorgeschlagen, bei der die Oberfläche der dem Frontkontakt (28) zugewandten Halbleiterschicht (20) als
Halbleiter-Inversionsschicht (24) ausgebildet ist, die
von den Ladungsträgern Elektronen und Löchern
durchtunnelbar ist.

FIG.1

## Photovoltaische Zelle

Die Erfindung bezieht sich auf eine photovoltaische Zelle mit einem ersten elektrisch leitenden Kontakt, einer ersten Halbleiterschicht, einer zweiten Halbleiterschicht anderen Leitungstypes und einem zweiten elektrisch leitenden Kontakt, die in Schichten übereinander angeordnet sind, und einer zwischen einer der Halbleiterschichten und dem nächstgelegenen elektrisch leitenden Kontakt angeordneten von Elektronen und Löchern durchtunnelbaren weiteren Schicht sowie auf ein Verfahren zur Herstellung einer solchen.

In der Photovoltaik stehen sich teure kristalline Solarzellen mit einem Wirkungsgrad von 10% und mehr und billige Dünnschicht-Solarzellen mit einem Wirkungsgrad von 4 bis 8% der Typen amorphes Silizium oder Kupfersulfid/Cadmiumsulfid - ($Cu_2S/CdS$) gegenüber. Erstere finden aufgrund der hohen Herstellungskosten keinen Markt. Aber auch die preiswerteren Dünnschicht-Solarzellen schaffen nicht den erhofften Durchbruch, da sie insbesondere über einen langen Zeitraum von z.B. 5 bis 10 Jahren nicht stabil genug sind, also ihre Ausgangsleistung nicht beibehalten können. Der Wirkungsgrad einer Dünnschicht-Solarzelle des Typs $Cu_2S/CdS$ ist stark abhängig von der Stöchiometrie des Kupfersulfids, welches in der Solarzelle die Funktion des Absorbers einnimmt, womit sich ein unmittelbarer Einfluß auf die Anzahl der gebildeten Ladungsträger ergibt und auf die erreichbare Stromdichte ableiten läßt. Um optimale Eigenschaften zu zeigen, sollte die Stöchiometrie zwischen $Cu_{1.995}S$ und $Cu_{2.000}S$ liegen. Da dieses Kupfersulfid die Oberfläche des Solarzellensystems darstellt, ist eine Wechselwirkung mit dem Sauerstoff der Luft oder eingesetzter Abdeckmaterialien zu bedenken. Dabei bildet sich Kupferoxid $Cu_{2-z}O$ - (mit $0 \leq z \leq 1$); dieses bezieht seine Kupferatome aus dem Kupfersulfid, welches somit als "Kupferlieferant" für das Kupferoxid wirkt. Da die Kupfersulfid-Schicht nur ca. 300 nm dick ist und das entstehende Kupferoxid bis zu einer Dicke von 5-10% der Dicke des Kupfersulfids zunehmen kann, ist eine starke Abnahme der Kupferstöchiometrie als Folge zu beobachten: die Stöchiometrie geht selbst bei Vorliegen sehr guter Ausgangswerte bis auf $Cu_{1.90}S$ zurück.

Daher wird in der DE-OS 21 52 895 versucht, den Wirkungsgrad einer Dünnschicht-Solarzelle des Typs Kupfersulfid/Cadmiumsulfid dadurch zu erhöhen und auf einem hohen Niveau beizubehalten, daß gleichzeitig zu einer Stöchiometrieverbesserung des Kupfersulfids auch die durch Degradation entstehende Kupferoxid-Schicht gebildet wird. Somit würde in den Herstellungsprozeß der Solarzelle eine Alterung des frontseitigen Halbleiters Kupfersulfid miteinbezogen werden. Hierzu wird vorgeschlagen, daß auf die Kupfersulfidschicht eine weitere Kupfer enthaltende Schicht aufgetragen wird, die dünn gegenüber der Kupfersulfidschicht ist. Dabei kann die zusätzliche Schicht z.B. durch Aufbringen einer Kupfer enthaltenden zusätzlichen Schicht und anschließendes Tempern in Vakuum oder in Luft gewonnen werden. Auch besteht die Möglichkeit, das Kupferinventar für die zusätzliche Schicht durch Reduktion der Kupfersulfidschicht an der Oberfläche zu erzeugen. Hierzu kann die Oberfläche durch Behandlung im Glimmfeld in einer Wasserstoffatmosphäre reduziert werden. All diese Maßnahmen, bei denen stets das Anordnen einer gesonderten Schicht auf die Kupfersulfidschicht vorgesehen ist, haben jedoch den erhofften Erfolg bezüglich der Langzeitstabilität nicht gezeigt.

Aufgabe der vorliegenden Erfindung ist es, eine photovoltaische Zelle der eingangs genannten Art derart weiterzubilden, daß sichergestellt ist, daß eine Veränderung der Stöchiometrie der Halbleiterschichten durch Verarmung aufgrund einer Diffusion zu den elektrisch leitenden Kontakten hin unterbleibt, ohne daß an diese besondere Anforderungen zu stellen sind.

Die Aufgabe wird erfindungsgemäß dadurch gelöst, daß die Schicht eine von Ionen nicht durchlässige Halbleiter-Inversionsschicht ist, daß die Inversionsschicht auf der Halbleiterschicht ausgebildet ist und daß zwischen der Halbleiter-Inversionsschicht und dem elektrisch leitenden Kontakt eine niederohmige die Elektronen oder Löcher gut ableitende Schicht angeordnet ist.

Durch das Ausbilden der Inversionsschicht an der Oberfläche der zweiten Halbleiter-Schicht wird sichergestellt, daß eine einmal vorgegebene Stöchiometrie nicht verschlechtert wird, wodurch eine Verringerung der bei Beleuchtung erreichbaren Stromdichte unterbleibt. Dies wird durch die Funktion der Inversionsschicht erreicht, die nämlich das Durchtunneln von Ionen unterbindet, jedoch Elektronen oder Löcher, also die den Wirkungsgrad der Solarzelle bestimmenden Ladungsträger durchläßt (da aufgrund der vergleichsweise zur Masse der Elektronen bzw. der Löcher erheblich größeren Masse der Ionen der Tunnelwahrscheinlichkeit vernachlässigbar klein wird).

Insbesondere zeichnet sich die Erfindung bei einer photovoltaischen Zelle in Form einer $Cu_{2-x}S/CdS$-Dünnschicht-Solarzelle mit $0 \leq x \leq 1$ dadurch aus, daß die $Cu_{2-x}S$-Schicht hochstöchiometrisch mit in etwa $x = 0,0000$ ausgebildet ist und daß auf der Oberfläche der

$Cu_{2,0000}S$-Schicht die Inversionsschicht angeordnet ist, die aus der $Cu_{2,0000}S$-Schicht gebildet ist. Dabei kann die Inversionsschicht eine Dicke von in etwa 1 bis 5 nm aufweisen.

(Hochstöchiometrisch wird im vorliegenden Fall aus der Sicht der Halbleitertechnik benutzt und bedeutet, daß jedem Schwefel-Ion genau 2 Kupfer-Ionen zugeordnet sind. Diese Leerstellenfreiheit soll durch $Cu_{2,0000}S$ beim Kupfersulfid zum Ausdruck gebracht werden. Angaben wie z.B. $Cu_{2,00}S$ oder gemäß der chemischen Nomenklatur $Cu_2S$ bringen nicht zum Ausdruck, daß die gewünschte Leerstellenfreiheit gegeben ist.)

Die Inversionsschicht entsteht dadurch, daß stark reduzierende Species, wie beispielsweise ein negativ geladenes Wasserstoffatom $H^-$) in Wechselwirkung mit der Oberfläche des p-Halbleiters, d.h. dem Kupfersulfid treten.

Diese reduzierenden Adsorbate wirken auf die Oberflächenschicht als Elektronendonatoren. Dies hat zur Folge, daß die Oberflächenschicht ein negatives, die darunterliegende aus Gründen der Ladungsneutralität ein positives Potential erhalten. Für Ionen wirken diese Schichten wie ein undurchdringbarer Potentialwall, wohingegen die Ladungsträger (Elektronen und Löcher) durchtunneln können. Die als Inversionsschicht aufgebaute Kupfersulfidoberfläche wirkt also wie eine semipermeable Wand.

Voraussetzung, daß eine entsprechende Inversionsschicht gebildet wird, ist, daß die frontseitige Kupfersulfidschicht reines Kupfersulfid darstellt, daß also weder Kupferoxid noch überschüssige Schwefelionen vorliegen. Da diese die Stöchiometrie der Kupfersulfidschicht störenden Anteile stets während der Herstellung der Kupfersulfidschicht auftreten, erfolgt erfindungsgemäß zunächst gezielt die Reduktion von Kupferoxid auf der Oberfläche der Kupfersulfidschicht und das Entfernen freier Schwefelionen, um anschließend durch Adsorption reduzierender Species und Wechselwirkung derselben mit dem p-Halbleiter $Cu_{2,0000}S$ dessen Oberfläche in die Inversionsschicht umzuwandeln. Wäre zu diesem Zeitpunkt beispielsweise noch eine Oxidschicht auf dem p-Halbleiter, so wäre die Bildung der Inversionsschicht im Kupfersulfid nicht möglich. Dies liegt darin begründet, daß bei Vorhandensein von Elektronenlöchern des nicht hochstöchiometrischen $Cu_{2-x}S$ oder $Cu_{2-z}O$ die Elektronen der adsorbierten Donatoren mit diesen Elektronenlöchern unmittelbar rekombinieren, wie es bei der DE-OS 21 52 895 sein muß (dort wird die Oberflächenschicht des Kupfersulfids in Kupfer umgewandelt, ohne daß das darunterliegende Volumenmaterial verändert wird). Durch die Inversionsschicht ist sichergestellt, daß eine Degradation der Kupfersulfidschicht auch über längere Zeiträume nicht erfolgt, daß also die einmal erreichte hohe Stöchiometrie beibehalten wird.

Da jedoch die reine Kupfersulfidschicht hochohmig ausgebildet ist, demzufolge ein Ladungsträgertransport, durch den der Wirkungsgrad der Solarzelle bestimmt wird, zu dem elektrisch leitenden Frontkontakt behindert wird, wird in weiterer Ausgestaltung der Erfindung die Reduktion auch nach Aufbau der Inversionsschicht fortgeführt, um die freie Oberfläche dieser in reines Kupfer umzuwandeln, welches ausschließlich in einem anschließenden Temperprozeß zu $Cu_{2-y}O$ oxidiert wird. Diese Oxidschicht ist um mindestens eine Größenordnung niederohmiger als $Cu_{2,0000}S$ und stellt eine die Ladungsträger gut ableitende Verbindung zwischen der frontseitigen Halbleiterschicht und dem auf der Oxidschicht angeordneten elektrisch leitenden Frontkontakt dar. (Grundsätzlich könnte auch auf die $Cu_{2-y}O$-Schicht verzichtet werden, sofern unmittelbar auf die Inversionsschicht ein dichtes Frontkontaktgitter aufgebracht werden würde. Dies hätte jedoch den Nachteil, daß eine nicht wünschenswerte Abschattung erfolgen würde. Dennoch würde eine Degradation nicht eintreten. Daher kann die Kupferschicht für das Kupferoxid auch in einem anderen Verfahren aufgebracht werden, wie beispielsweise in einem Aufdampfprozeß oder durch eine galvansche Abscheidung.)

Um die Reduktion gezielt durchzuführen, wird in einem eigenerfinderischen Vorschlag die aus der DE-OS 21 52 895 bekannte Entladung derart modifiziert, daß nach Auftragen des elektrisch leitenden Rückkontakts, der Cadmiumsulfid-und der $Cu_{2-x}S$-Schicht diese als Einheit in vorzugsweise die positive Säule der Glimmentladung in eine Wasserstofatmosphäre gebracht werden. Vorzugsweise wird der Träger mit den darauf ange ordneten Schichten in einen zunächst evakuierten Raum (in etwa $10^{-6}$ mbar ($10^{-4}$ Pa)) gebracht, um diesen anschließend mit Wasserstoff eines Druckes von in etwa 0,5 mbar (50 Pa) zu fluten. Nachdem die Druckverhältnisse sich auf 0,5 mbar (50 Pa) stabilisiert haben, erfolgt die eigentliche Glimmentladung, bei der Wasserstoffradikale bzw. $H^-$Ionen die Reduktion der $Cu_{2-x}S$-Schicht in einem Umfang bewirken, daß die hochstöchiometrische $Cu_{2,0000}S$-Schicht ausgebildet wird, deren Oberfläche in die Inversionsschicht und deren Oberfläche wiederum in reines Kupfer umgewandelt wird. Dabei muß sichergestellt sein, daß die reduzierenden Species nicht lediglich wie in der DE-OS 21 52 895 beschrieben die Reduktion der Oberfläche der $Cu_{2-x}S$-Schicht zu elementarem Kupfer bewirken, während das darunterliegende Volumenmaterial als $Cu_{2-x}S$-Schicht unverändert bleibt.

Sodann erfolgt ein Tempern. Dieses kann z.B. entweder bei 180°C an Luft oder 200°C im Vakuum und anschließend bei 150°C an Luft erfolgen. Durch die Reduktion der $Cu_{2,0000}S$-Schicht nach Ausbildung der Inversionsschicht und das Tempern erfolgt eine kontrollierte Oxidbildung. Vergleichsweise ist eine definierte Dicke des Kupferoxids $Cu_{2-y}O$ bei anderen Herstellverfahren nicht möglich, wenn die für die Oxidschicht erforderliche Kupferschicht unmittelbar auf den frontseitigen Halbleiter aufgedampft wird. Hierbei vermischen sich Oxid aus dem Temperschritt und Restoxide, die bereits während des Herstellungsprozesses der Halbleiterschicht gebildet worden sind.

Ferner ist besonders hervorzuheben, daß die Verfahrensschritte

Ausbildung der hochstöchiometrischen $Cu_{2,0000}S$-Schicht,

Ausbildung der Inversionsschicht und gegebenenfalls

Bilden von Kupfer und Ausbildung der Kupferoxidschicht

kontrolliert nacheinander durch Verfolgen des $H_2S$-Partialdrucks ablaufen, welcher im Glimmkessel feststellbar ist. So muß z.B. bei einer Stromdichte von $10\mu A/cm^2$ Halbleiterschichtbei zwischen Kathode und Anode liegender Spannung von 300 V und einem Gasdruck von in etwa 50 Pa (5 • $10^{-4}$ bar) im Glimmkessel der Partialdruck des $H_2S$ zu Beginn des Glimmprozesses und zwar über einen Zeitraum von in etwa 5 min. stark ansteigend - (Ausbildung der $Cu_{2-x}$ S-Schicht in eine $Cu_2S$-Schicht), anschließend nahezu unverändert (bis ca. 10 min seit Prozeßbeginn) (Ausbildung der Inversionssicht) und dann leicht ansteigend sein - (Ausbildung der Kupferschicht).

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung der Zeichnung.

Es zeigen:

Fig. 1 eine schematische Darstellung eines Ausschnitts einer Dünnschicht-Solarzelle,

Fig. 2 eine Anordnung einer Vorrichtung zur Glimmentladung und

Fig. 3 Verlauf eines Herstellungsprozesses unter Beobachtung des $H_2S$-Partialdrucks.

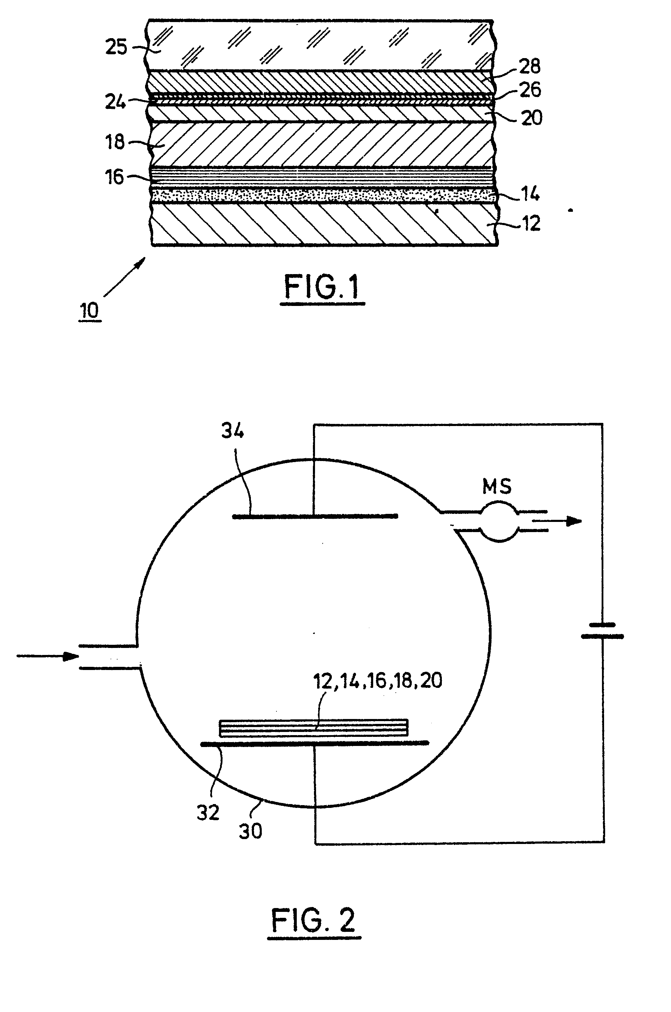

In Fig. 1 ist rein schematisch und in vergrößerter Darstellung eine Kupfersulfid-Cadmiumsulfid-Solarzelle (10) dargestellt. Auf einem Träger wie einem Substrat (12), das z.B. in Lösungsmittel mit Ultraschall gereinigt ist, kann zunächst eine Haftvermitt lungsschicht (14) in Form von z.B. aufgedampftem oder gesputtertem Titan aufgetragen werden, um auf diese einen ersten elektrisch leitenden Rückkontakt (16) anzuordnen.

Dieser kann aus Silber bestehen und ebenfalls durch Aufdampfen oder Sputtern aufgetragen sein. Auf die Silberschicht (16) wird sodann eine Schicht aus Cadmiumsulfid (18) aufgedampft. Diese kann zur Verringerung von Reflexionen und zum Herausätzen von Korngrenzen kurzzeitig in wässriger Salzsäure behandelt sein. Die Dicke der Cadmiumsulfidschicht beträgt in etwa 10 bis 20 $\mu m$. Auf der Cadiumsulfidschicht (18) wird anschließend eine Kupfersulfidschicht (20) (Dicke ca. 200 -500 nm) dadurch erzeugt, daß die Cadmiumsulfidschicht (18) in eine heiße, vorzugsweise wässrige Kupfer(I)-Chlorid-Lösung getaucht wird, wobei die Oberfläche des Cadmiumsulfids in einem IonenAustauschprozeß von Cadmium gegen Kupfer in Kupfersulfid umgewandelt wird.

Diese $Cu_{2-x}S$-Schicht weist eine Stöchiometrie mit x z.B. von 0,01 bis 0,04 auf. Gleichzeitig ist ein Teil der Oberfläche der Kupfersulfidschicht (20) oxidiert. Dieses $Cu_{2-z}$ mit $0 \leq z \leq 1$ ist der Fig. 1 nicht zu entnehmen. Diese $Cu_{2-z}$ O-Schicht und die nicht hochstöchiometrische $Cu_{2-x}S$-Schicht beeinflußt negativ den Wirkungsgrad der photovoltaischen Zelle (10). Außerdem kann über einen längeren Zeitraum eine Degradation, also eine Kupferverarmung in der Kupfersulfidschicht (20) auftreten.

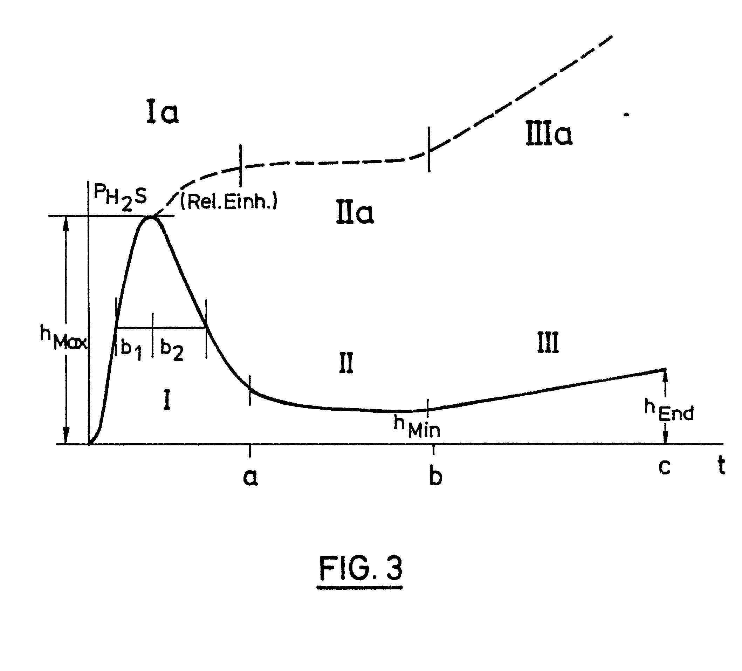

Um dies zu vermeiden, wird die Kupfersulfidschicht (20) kontrolliert reduziert und zwar in einer Glimmentladung in Wasserstoffatmosphäre. Hierzu wird das Substrat (12) mit den Schichten (14, 16, 18) und (20) im Bereich einer Anode (32) angeordnet, die zusammen mit einer Kathode (34) in einem Glimmkessel (30) angeordnet wird. Sodann wird der Glimmkessel (30) bis auf einen Druck von etwa $10^{-6}$ mbar ($10^{-4}$ Pa) evakuiert. Anschließend erfolgt ein kontrolliertes Fluten mit Wasserstoff, und zwar in einem Umfang, daß sich ein konstanter Druck von in etwa 0,5 mbar (50 Pa) einstellt. Sodann findet die Glimmentladung statt. Die Stromdichte beträgt 10 $\mu A/cm^2$ Hal bleiterschicht. Die zwischen den Elektroden angelegte Spannung beläuft sich auf 300 V. Durch die Wasserstoffradikale bzw. $H^-$ Ionen erfolgt zunächst eine vollständige Reduzierung der $Cu_{2-y}O$-Schicht und ein Entfernen überschüssiger Schwefel-Ionen der $Cu_{2-x}S$-Schicht (20). Diese Reduktion kann durch den $H_2S$-Anteil des den Glimmkessel (30) durchströmenden Wasserstoffs verfolgt werden (siehe Fig. 3). So zeigt der Anteil des $H_2S$, ob die Reduktion abgeschlossen ist. Bejahendenfalls ergibt sich eine hochstöchiometrische $Cu_{2-x}S$-Schicht mit in etwa x = 0,0000. Durch weitere Behandlung dieser Schicht wird die Oberfläche in eine Inversionsschicht (24) umgewandelt, die eine Schichtdicke von 1 bis 5 nm aufweisen kann. Durch diese Inversionsschicht (24) können Eletronen und Löcher, also die den Wirkungsgrad der fertigen Solarzelle bestimmenden Ladungsträger hindurchtunneln, wohingegen Ionen dies nicht können. Dadurch wird sichergestellt, daß eine Stöchiometrieverarmung der $Cu_{2,0000}S$-Schicht (20) nicht auftreten kann. (Dies wurde durch mehrstündiges Tempern bei 180°C an Luft dadurch nachgewiesen, daß die Schichtdicke des Kupferoxids nicht zunimmt.)

Da jedoch die $Cu_{2,0000}S$-Schicht (20) und die Inversionsschicht (24) hochohmig sind, muß dafür gesorgt werden, daß auf diese eine verhältnismäßig niederohmige Schicht (26) aufgetragen wird, um über diese zu einem Frontkontakt Ladungsträger zu leiten. Diese zusätzliche Schicht (26) wird dadurch gewonnen, daß die freie Oberfläche der Inversionsschicht (24) im Glimmprozeß reduziert wird, so daß sich eine reine Kupferschicht (26) ausbildet. Die Dicke dieser Schicht beträgt in etwa 1 nm und kann gezielt durch den Glimmprozeß eingestellt werden. Sodann wird das Substrat (12) mit den Schichten (14, 16, 18, 20, 24. 26) aus dem Glimmkessel (30) entfernt, um anschließend getempert zu werden, z.B. in Normalatmosphäre bei 180°C oder zunächst im Vakuum bei 200°C und anschließend in Normalatmosphäre bei 150°C. Hierdurch wird die Kupferschicht (26) oxidiert, also eine $Cu_{2-y}O$-Schicht mit $0 \leq y \leq 1$ ausgebildet. Auf diese niederohmige Schicht (26) wird sodann ein Frontkontakt (28) angeordnet, über den die Ladungsträger abgeleitet werden. Schließlich kann die Solarzelle (10) über Abdeckmaterial und eine Abdeckplatte (25) verkapselt werden.

Eine entsprechend hergestellte Solarzelle (10) weist eine hochstöchiometrische Kupfersulfidschicht (20) auf, die aufgrund der an ihrer Oberfläche angeordneten Inversionsschicht (24) einer Stöchiometrieverarmung auch über einen langen Zeitraum von z.B. 5 bis 10 Jahren nicht unterliegt. Eine die Lebensdauer von Solarzellen (10) negativ beeinflussende Degradation tritt folglich nicht ein. Eine kostengünstige Herstellung ergibt sich u.a. dadurch, daß die Dünnschicht-Solarzellen großflächig hergestellt und dem Glimmprozeß unterworfen werden können, der gut beherrschbar ist.

Um verfolgen zu können, ob die Ausbildung der Dünnschicht-Solarzelle (10) in Bezug auf die Kupfersulfidschicht (20) und der darüber angeordneten Inversionsschicht (24) und gegebenenfalls der Kupfer-bzw. Kupferoxidschicht (26) den Anforderungen genügt, kann der während der Glimmprozesses im Glimmkessel (30) ablaufende Prozeß anhand des $H_2S$-Partialdrucks verfolgt werden. Hierzu ist ergänzend zu bemerken, daß der in dem Glimmkessel (30) eingestellte Partialdruck von $5 \cdot 10^{-4}$ bar = 50 Pa bei durchströmendem Wasserstoffgas eingehalten wird.

Sofern nicht bei auszutauschender Wasserstofatmosphäre geglimmt wird, ergibt sich in dem dem Bereich 1 entsprechenden Zeitraum ein starker Anstieg (Bereich Ia), um anschließend ein Plateau zu durchlaufen (Bereich IIa). Anschließend steigt der $H_2S$-Partialdruck kontinuierlich weiter an - (Bereich IIIa).

In Fig. 2 ist dies durch Zu-und Ablaßleitungen, die mit Pfeilen versehen sind, angedeutet. In der Ablaßleitung ist ferner ein mit MS bezeichnetes Massenspektrometer angeordnet, um den $H_2S$-Partialdruck zu bestimmen (selbstverständlich können anstelle des $H_2S$-Partialdrucks auch andere Elemente, wie z.B. das aus dem Kupferoxid entstehende $H_2O$ als Parameter herangezogen werden).

Anhand der Fig. 3 wird nun verdeutlicht, wann der Herstellungsprozeß erfindungsgemäß abläuft, wenn also zunächst das auf der Kupfersulfidschicht vorhandene Kupferoxid und die in der Kupfersulfidschicht vorhandenen überschüssigen Schwefelionen reduziert werden, um eine hochstöchiometrische $Cu_{2,0000}S$-Schicht (20) zu erzeugen. In der $H_2S$-Partialdruckkurve, die über der Zeit t aufgetragen ist, äußert sich dies in dem Bereich I mit einem steil ansteigenden $H_2S$-Anteil, der dann wieder abfällt (Zeitpunkt a). Dabei muß die Spitze dieser Kurve in Bezug auf deren Halbwertsbreite zu der kürzeren Zeit hin verschoben sein, d.h., daß b2 größer als b1 ist.

Anschließend im Bereich II nimmt der $H_2S$-Partialdruck leicht ab, um zum Zeitpunkt b ein Minimum zu erreichen. Sofern dieser Bereich feststellbar ist, dessen Zeitdauer in etwa dem des Bereichs I entspricht, ist davon auszugehen, daß sich die Inversionsschicht (24) ausgebildet hat. Nach dem Bereich II steigt in dem Bereich III der $H_2S$-Partialdruck kontinuierlich an. In diesem Bereich wird aus dem Oberflächenbereich der Kupfersulfid-Inversionsschicht Schwefel unter Bildung von $H_2S$ entzogen. Dabei bildet sich gleichzeitig Kupfer.

In dem Zeitraum c -b kann kontrolliert die Dicke der Kupferschicht eingestellt werden und damit letztendlich die Dicke der Kupferoxidschicht.

Im Ausführungsbeispiel der Fig. 3 belaufen sich die Zeiträume a, b und c bei einem konstant eingestellten Innendruck im Glimmkessel (30) von $5 \cdot 10^{-4}$ bar ( = 50 Pa), bei einer Stromdichte von 10 $\mu A/cm^2$ Halbleiterschicht, einer Spannung von 300 V zwischen den Elektroden (32) und (34) sowie einer Durchspülung des Glimmkessels (30) derart, daß pro Minute der Kesssel (30) zweimal vollständig durchspült wird, von a = 5 min, b -a = 5 min und c -b in etwa 10 min.

Ganz allgemein kann gesagt werden, daß die Fläche des Bereichs I zu der des Bereichs II im Verhältnis von (2,5 + 0,5) zu 1 stehen muß. Sind diese Werte eingehalten und ist ferner das Maximum des Bereichs I zur kürzeren Zeit hin verschoben, so ist sichergestellt, daß die fertige Dünnschicht-Solarzelle (10) den erfindungsgemäßen Aufbau aufweist.

Selbstverständlich gilt die erfindungsgemäße Lehre nicht nur für die beschriebene "Frontwall"-Solarzelle (10), in der das Kupfersulfid die obere, dem Frontkontakt (28) zugewandte Halbleiterschicht (20) ist. Vielmehr ist diese Lehre auch beim Herstellen einer "Backwall"-Solarzelle gültig, wenn durch den Aufbau der Solarzelle Glas (12) / Transparenter Frontkontakt (z. B. $SnO_x$) (14, 16) / CdS-Schicht (18) / $Cu_{2-x}$S-Schicht (20) / Rückkontakt - (28) das Kupfersulfid die untere, dem rückseitigen elektrisch leitenden Kontakt zugewandte HalbleiterSchicht ist.

Die selbe Gültigkeit trifft für die Halbleitermaterialien $Cu_2S/Zn_wCd_{1-w}S$ mit $0 \leq w \leq 0{,}3$ zu, womit der Wirkungsgrad der Solarzelle (10) sich auf 10% bis 13% verbessern läßt.

## Ansprüche

1. Photovoltaische Zelle mit einem ersten elektrisch leitenden Kontakt, einer ersten Halbleiterschicht, einer zweiten Halbleiterschicht anderen Leitungstypes und einem zweiten elektrisch leitenden Kontakt, die in Schichten übereinander angeordnet sind, und einer zwischen einer der Halbleiterschichten und dem nächstgelegenen elektrisch leitenden Kontakt angeordneten von Elektronen und Löchern durchtunnelbaren weiteren Schicht,
**dadurch gekennzeichnet,**
daß die Schicht eine von Ionen nicht durchlässige Halbleiter-Inversionsschicht ist, daß die Inversionsschicht auf der Halbleiterschicht ausgebildet ist und daß zwischen der Halbleiter-Inversionsschicht und dem elektrisch leitenden Kontakt eine niederohmige die Elektronen oder Löcher gut ableitende Schicht angeordnet ist.

2. Photovoltaische Zelle nach Anspruch 1 in Form einer $Cu_{2-x}$S/CdS-Dünnschichtsolarzelle mit x $\leq 0{,}0005$,
**dadurch gekennzeichnet,**
daß die $Cu_{2-x}$S-Schicht (20) eine p-Halbleiterschicht und hochstöchiometrisch mit in etwa x = 0,0000 ist, daß die Inversionsschicht eine n-Halbleiterschicht und aus der Oberfläche der $Cu_{2,0000}$S-Schicht ausgebildet ist und daß zwischen der Inversionsschicht und elektrisch leitendem Kontakt eine $Cu_{2-y}$O-Schicht mit $0 \leq y \leq 1$ angeordnet ist.

3. Photovoltaische Zelle nach Anspruch 2,
**dadurch gekennzeichnet,**
daß die Inversionsschicht (24) eine Dicke von d = 1 bis 5 nm aufweist.

4. Photovoltaische Zelle nach Anspruch 2,
**dadurch gekennzeichnet,**
daß auf der Inversionsschicht (24) die $Cu_{2-y}$O-Schicht (26) angeordnet ist, die eine Dicke von in etwa 1 nm aufweist, wobei die $Cu_{2-y}$O-Schicht aus der Oberflächenschicht der Inversionsschicht (24) gebildet ist.

5. Photovoltaische Zelle nach zumindest Anspruch 2,
**dadurch gekennzeichnet,**
daß die CdS-Schicht (18) ganz oder teilweise durch eine $Zn_wCd_{1-w}$S-Schicht mit $0 \leq w \leq 0{,}3$ ersetzt ist.

6. Verfahren zur Herstellung einer photovoltaischen Zelle in Form einer $Cu_{2-x}$S/CdS-Dünnschicht-Solarzelle umfassend die Verfahrensschritte
a) Anordnen einer CdS-Schicht auf einen ersten elektrisch leitenden Kontakt,
$b_1$) Aufbringen einer $Cu_{2-x}$S-Schicht auf die CdS-Schicht z.B. durch Aufdampfen oder Sputtern von Kupfersulfid oder Eintauchen der Cadmiumsulfid-Schicht in eine heiße, vorzugsweise wässrige Kupfer(I)-chlorid-Lösung,
c) Aufbringen eines elektrisch leitenden Frontkontakts und gegebenenfalls Verkapseln der Solarzelle,
**gekennzeichnet durch**
sich an den Verfahrensschritt $b_1$) anschließende Verfahrensschritte
$b_2$) Reduktion in der Glimmentladung von auf der $Cu_{2-x}$S-Schicht vorhandenem $Cu_{2-z}$ mit $0 \leq z \leq 1$ und überschüssigen Schwefel-Ionen aus der $Cu_{2-x}$S-Schicht bis zur Gewinnung einer hochstöchiometrischen $Cu_{2,0000}$S-Schicht,
$b_3$) Ausbilden einer Inversionsschicht auf und aus der hochstöchiometrischen $Cu_{2,0000}$S-Schicht durch Adsorption von $H^-$-Ionen aus der Wasserstofatmosphäre der Glimmentladung,
$b_4$) Reduktion der freien Oberfläche der Inversionsschicht zu elementarem Kupfer oder Aufbringen von elementarem Kupfer auf der Inversionsschicht,
$b_5$) Oxidieren elementaren Kupfers zu $Cu_{2-y}$O mit $0 \leq y \leq 1$.

7. Verfahren nach Anspruch 6,
**dadurch gekennzeichnet,**
daß zur Bildung der Inversionsschicht die $Cu_{2,0000}$S-Schicht in der positiven Säule der Glimmentladung angeordnet wird.

8. Verfahren nach Anspruch 6,
**dadurch gekennzeichnet,**
daß die Glimmentladung zur Bildung der Inversionsschicht in einem evakuierten Raum erfolgt, der zunächst auf einen Druck p mit $p \approx 10^{-6}$ mbar ($10^{-4}$ Pa) eingestellt wird, und daß der Raum anschließend mit Wasserstoff zur Erzielung eines Drucks von 0,5 mbar (50 Pa) geflutet wird, um die Glimmentladung durchzuführen.

9. Verfahren nach Anspruch 8,

**dadurch gekennzeichnet,**

daß der Glimmprozeß bei einer Stromdichte von 10 $\mu A/cm^2$ Halbleiterschicht bei einer zwischen den Elektroden angelegten Spannung von 300 V erfolgt.

10. Verfahren nach Anspruch 6,

**dadurch gekennzeichnet,**

daß die Wasserstoffatmosphäre des Glimmraums während des Glimmprozesses ohne Änderung des Innendrucks ausgetauscht wird,

11. Verfahren nach Anspruch 10,

**dadurch gekennzeichnet,**

daß der Austausch vorzugsweise in etwa 2 mal pro Minute erfolgt.

12. Verfahren nach Anspruch 6,

**dadurch gekennzeichnet,**

daß der zeitliche Verlauf des Glimmprozesses derart eingestellt wird, daß der durch die Reduktion der $Cu_{2-x}S$-Schicht entstehende $H_2S$-Partialdruck gemessen bei kontinuierlich auszutauschender Wasserstoffatmosphäre zunächst steil ansteigt und nach Durchlaufen eines Maximums wieder steil abfällt (Bereich I),. wobei das Maximum zu kürzerer Zeit hin verschoben ist, daß sich anschließend eine allmähliche Verringerung des $H_2S$-Partialdrucks bis zu einem Minimum (Bereich II) ergibt und daß sodann der $H_2S$-Partialdruck nahezu kontinuierlich ansteigt (Bereich III).

13. Verfahren nach Anspruch 12,

**dadurch gekennzeichnet,**

daß sich das Verhältnis der Fläche des Bereichs I zu der des Bereichs II wie $F_I : F_{II} = (2,5 \pm 0,5) : 1$ verhält.

14. Photovoltaische Zelle nach zumindest Anspruch 1,

**dadurch gekennzeichnet,**

daß die photovoltaische Zelle (10) eine Frontwall- oder Backwall-Solarzelle ist.

FIG.1

12,14,16,18,20

FIG. 2

FIG. 3